(19) Europäisches Patentamt
European Patent Office
Office européen des brevets

(11) **EP 4 614 170 A1**

(12) **EUROPEAN PATENT APPLICATION**

(43) Date of publication:
**10.09.2025 Bulletin 2025/37**

(21) Application number: **24214758.5**

(22) Date of filing: **22.11.2024**

(51) International Patent Classification (IPC):
**G01R 31/392** (2019.01)    **G01R 31/396** (2019.01)

(52) Cooperative Patent Classification (CPC):
**G01R 31/392; G01R 31/3835**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.03.2024 KR 20240030745**

(71) Applicant: **SAMSUNG SDI CO., LTD.**
**Yongin-si, Gyeonggi-do 17084 (KR)**

(72) Inventors:
• **LEE, Dae Sung**
**16678 Suwon-si (KR)**
• **BAEK, Jin Seon**
**16678 Suwon-si (KR)**
• **KIM, Hyun Soo**
**16678 Suwon-si (KR)**
• **DO, Hyun Chul**
**16678 Suwon-si (KR)**

(74) Representative: **Marks & Clerk LLP**
**15 Fetter Lane**
**London EC4A 1BW (GB)**

(54) **ABNORMAL CELL DIAGNOSIS DEVICE AND METHOD USING CELL VOLTAGE DEVIATION**

(57)     Disclosed herein is an abnormal cell diagnosis device (200) and method using a cell voltage deviation, which uses a method of finding outliers compared to a median of all battery cell data to acquire battery cell information according to a time point and a situation in which a battery system is operated and use a voltage difference and which increases efficiency of abnormal cell detection by applying a condition according to a characteristic of a charging state in each section. The abnormal cell diagnosis device includes a voltage mea- surement module (210) configured to measure (610) an initial open circuit voltage (OCV) or closed circuit voltage (CCV) of each battery cell (10, 10a, 10b), a timer (220) configured to count (620) a minimum rest time for each battery cell, and a processor (230) configured to calculate (630) an inter quartile range (IQR) based on the initial OCV or CCV depending on whether the minimum rest time is satisfied, set (660) an outlier criterion, and detect (680) an abnormal cell on the basis of the set outlier criterion.

FIG. 6

EP 4 614 170 A1

## Description

## BACKGROUND

### 1. Field

Aspects of embodiments of the present disclosure relates to a device and a method that can diagnose an abnormal cell using a cell voltage deviation.

### 2. Discussion of the Related Art

A battery management system (BMS) has a function of estimating a battery charging and discharging state and continuously measuring a temperature and a battery voltage to detect and control a failure. The purpose of this function is to detect an abnormal phenomenon from battery cells in advance and prevent a dangerous situation.

In an abnormal cell, there may be a high probability of a problem occurring, but there is a problem in that it cannot be defined as having specific conditions. Numerous tests are conducted to find these specific conditions, but most test results are wide ranges of values that normal cells can also have, and these values cannot be specified as absolute criteria for the problem.

When the exact cause cannot be identified in situations in which causes of the problem are diverse, abnormal cells can be detected through a set threshold value by assuming the worst case scenario, but the probability of over-detection of normal cells determined by the threshold value may be a problem with a cell detection method.

The above information disclosed in this Background section is for enhancement of understanding of the background of the present disclosure, and therefore, it may contain information that does not constitute related (or prior) art.

## SUMMARY

The present invention is directed to providing an abnormal cell diagnosis device and method using a cell voltage deviation, which involves using a method of finding outliers compared to a median of all battery cell data to acquire battery cell information according to a time point and a situation in which a battery system is operated and use a voltage difference between cells, and which increases efficiency of abnormal cell detection by applying a condition according to a characteristic of a charging state in each section.

However, objects that the present invention intends to achieve are not limited to the above-described objects and other objects that are not described may be clearly understood by those skilled in the art from the following description.

According to an aspect of the present invention, there is provided an abnormal cell diagnosis device using cell voltage deviation, which includes a voltage measurement module configured to measure an initial open circuit voltage (OCV) or closed circuit voltage (CCV) of each battery cell, a timer configured to count a minimum rest time for each battery cell, and a processor configured to calculate an inter quartile range (IQR) based on the initial OCV or CCV depending on whether the minimum rest time is satisfied, set an outlier criterion, and detect an abnormal cell on the basis of the set outlier criterion.

At least some of the above and other features of the invention are set out in the claims.

## BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:

FIG. 1 is a diagram illustrating an example of a battery module according to one embodiment of the present invention;
FIG. 2 is a block diagram for describing an abnormal cell diagnosis device using a cell voltage deviation according to one embodiment of the present invention;
FIGS. 3 to 5 are example diagrams for describing a method of setting an outlier criterion according to one embodiment of the present invention;
FIG. 6 is a flowchart for describing an abnormal cell diagnosis method using a cell voltage deviation according to one embodiment of the present invention; and
FIG. 7 is a flowchart for describing an abnormal cell diagnosis method using a cell voltage deviation according to another embodiment of the present invention.

## DETAILED DESCRIPTION OF EXAMPLE EMBODIMENTS

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

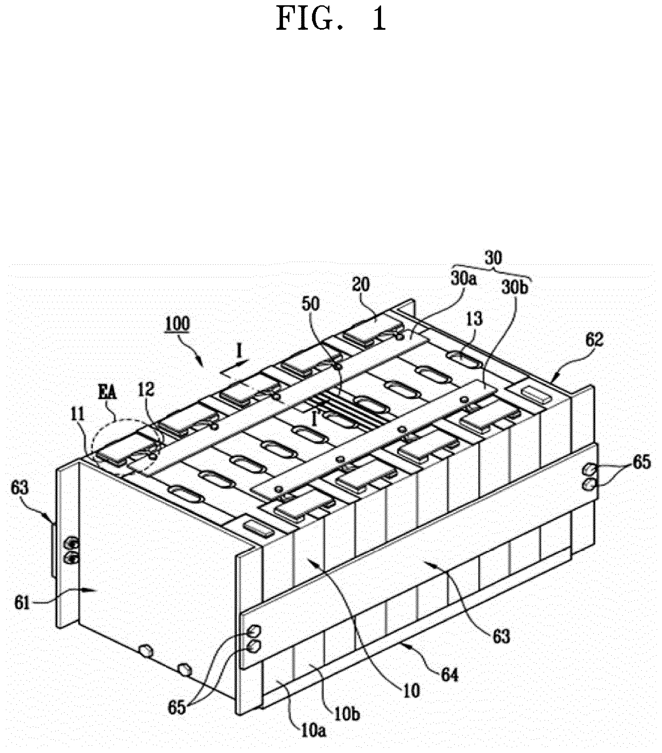

FIG. 1 is a diagram illustrating an example of a battery module according to one embodiment of the present invention.

Referring to FIG. 1, a battery module 100 according to the present invention includes a plurality of battery cells 10 provided with terminals 11 and 12 and arranged in one direction, a connection tab 20 which connects a battery cell 10a to an adjacent battery cell 10b, and a protection circuit module 30 with one end connected to the connection tab 20. The protection circuit module 30 may be a battery management system (BMS). In addition, the connection tab 20 includes a body which contacts the terminals 11 and 12 between the adjacent battery cells 10a and 10b, and an extension extending from the body to connect to the protection circuit module 30. The connection tab 20 may be a bus bar.

First, the battery cell 10 may be formed of a battery case and an electrode assembly and an electrolyte which are accommodated in the battery case. The electrode assembly and the electrolyte react electrochemically to generate energy. The terminals 11 and 12 electrically connected to the connection tab 20 and a vent 13 that is a discharge passage for a gas generated inside the battery cell 10 may be provided on one side of the battery cell 10. The terminals 11 and 12 of the battery cell 10 may be a positive electrode terminal 11 and a negative electrode terminal 12 having different polarities, and the terminals 11 and 12 of the adjacent battery cells 10a and 10b may be electrically connected in series or in parallel by the connection tab 20. Meanwhile, although an example of the serial connection has been described, the present invention is not limited to this structure, and of course, various connection structures can be employed as necessary. In addition, the number and arrangement of the battery cells 10 are not limited to the structure shown in FIG. 1 and can be changed as necessary.

The plurality of battery cells 10 may be disposed in one direction so that wide surfaces of the battery cells 10 face each other, and the plurality of disposed battery cells 10 may be fixed by housings 61, 62, 63, and 64. The housings 61, 62, 63, and 64 may include a pair of end plates 61 and 62 facing the wide surfaces of the battery cells 10, and a side plate 63 and a bottom plate 64 which connect the pair of end plates 61 and 62. The side plate 63 may support a side surface of the battery cell 10, and the bottom plate 64 may support a bottom surface of the battery cell 10. In addition, the pair of end plates 61 and 62, the side plate 63, and the bottom plate 64 may be connected by members such as bolts 65.

Electronic components and protection circuits may be mounted on the protection circuit module 30, and the protection circuit module 30 may be electrically connected to the connection tab 20. The protection circuit module 30 may include a first protection circuit module 30a and a second protection circuit module 30b, which extend from different positions in a direction in which the plurality of battery cells 10 are disposed. In this case, the first protection circuit module 30a and the second protection circuit module 30b may be spaced apart at a predetermined distance and positioned parallel to each other so that each of the first protection circuit module 30a and the second protection circuit module 30b may be electrically connected to an adjacent connection tab 20. For example, the first protection circuit module 30a is formed to extend on one upper side of the plurality of battery cells 10 in the direction in which the plurality of battery cells 10 are disposed, and the second protection circuit module 30b extends on the other upper side of the plurality of battery cells 10 in the direction in which the plurality of battery cells 10 are disposed. The second protection circuit module 30b may be positioned to be spaced a predetermined distance from the first protection circuit module 30a with the first protection circuit module 30a and the vent 13 interposed therebetween and disposed parallel to the first protection circuit module 30a.

In this way, the two protection circuit modules are separately disposed parallel to each other in the direction in which the plurality of battery cells are disposed so that an area of a printed circuit board (PCB) constituting the protection circuit module is minimized. The protection circuit module is formed of the two protection circuit modules so that an unnecessary PCB area is minimized. In addition, the first protection circuit module 30a and the second protection circuit module 30b may be connected to each other by a conductive connection member 50. In this case, one side of the connection member 50 is connected to the first protection circuit module 30a, and the other side thereof is connected to the second protection circuit module 30b so that an electrical connection can be made between the two protection circuit modules. The connection may be performed by any one of soldering, resistance welding, laser welding, and projection welding.

In addition, the connection member 50 may be, for example, an electric wire. In addition, the connection member 50 may be made of an elastic or flexible material. It is possible to check and manage whether a voltage, a temperature, and a current of the plurality of battery cells 10 are normal through the connection member 50. That is, information such as a voltage, a current, and a temperature received by the first protection circuit module from adjacent connection tabs and information such as a voltage, a current, and a temperature received by the second protection circuit module from adjacent connection tabs may be integrated and managed by the protection circuit module through the connection member.

In addition, when the battery cell 10 swells, an impact is absorbed by elasticity or flexibility of the connection member 50 so that the first and second protection circuit modules 30a and 30b are prevented from being damaged.

In addition, a shape and a structure of the connection member 50 are not limited to those shown in FIG. 1.

In this way, since the protection circuit module 30 is provided as the first and second protection circuit modules 30a and 30b, the area of the PCB constituting the protection circuit module may be minimized so that a space inside the battery module can be secured. This improves work efficiency by not only connecting the connection tab 20 to the protection circuit module 30, but also making repairs easier when an abnormality is detected in the battery module.

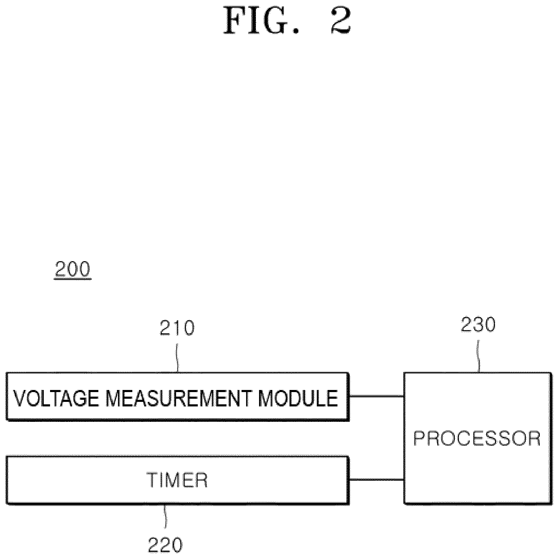

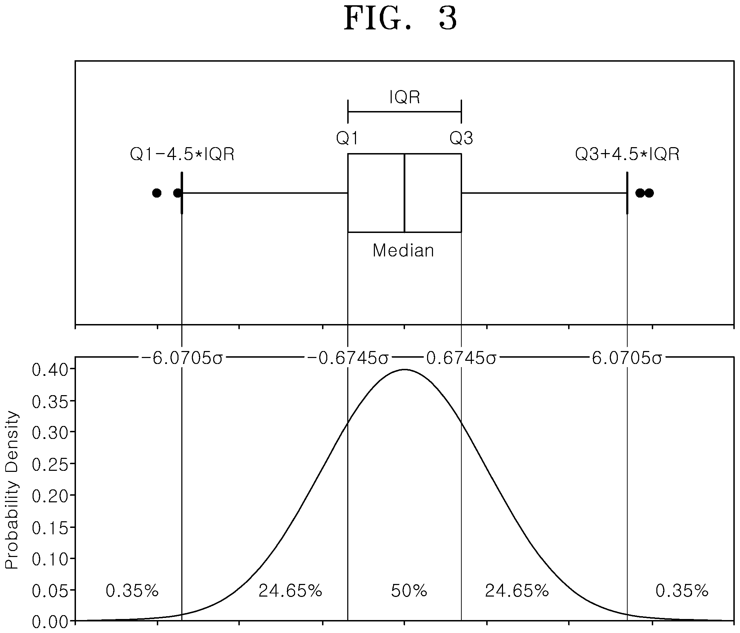

FIG. 2 is a block diagram for describing an abnormal cell diagnosis device using a cell voltage deviation according to one embodiment of the present invention, and FIGS. 3 to 5 are example diagrams for describing a method of setting an outlier criterion according to one embodiment of the present invention.

Referring to FIG. 2, an abnormal cell diagnosis device using cell voltage deviation 200 according to one embodiment of the present invention may include a voltage measurement module 210, a timer 220, and a processor 230.

The voltage measurement module 210 may measure an initial open circuit voltage (OCV) or closed circuit voltage (CCV) for each battery cell. To this end, the voltage measurement module 210 may include a voltage sensor.

The timer 220 may be started for each battery cell upon suspension of operation of the respective battery cell. For example, upon suspension of a charging operation or suspension of a discharge operation. The timer 220 may be reset to zero upon resumption or execution of an operation of the battery cell. The timer 220 may count a rest time for each battery cell (being the time the battery cell is inactive) for comparison to a minimum rest time for each battery cell. In some examples, the minimum rest time may be preset to, for example, two hours.

The processor 230 may detect a voltage of an individual battery cell as an outlier of a voltage distribution of the battery using an inter quartile range (IQR). The processor 230 may distinguish an idle situation (battery idle mode) from a charging situation (battery charging mode) and add an activation condition and a condition for identification to complement an IQR method. The processor may distinguish an idle situation or a charging situation by determining the state of charge (SOC) of the battery pack and determining where a rate of change in the SOC is increasing. If the SOC is increasing, the battery pack is in a charging mode.

The processor 230 may calculate an IQR based on the initial OCV or CCV depending on whether the minimum rest time is satisfied and set an outlier criterion for detecting an abnormal cell. Hereinafter, a process of setting an outlier criterion according to the battery idle mode and the battery charging mode will be described with reference to FIGS. 3 to 5.

In the battery idle mode, the processor 230 may detect an outlier in a situation in which the minimum rest time is satisfied to obtain a stable voltage. In this case, a sensing circuit for measurement should have no problems, and a voltage and a temperature of each cell may be measured before a high voltage is connected. The processor 230 may calculate a median, an IQR, and an outlier criterion of the voltage of an entire battery pack on the basis of the measured voltage.

To this end, when the minimum rest time is satisfied, the processor 230 may calculate an IQR for the battery pack based on the initial OCV measurements for each battery cell and set an outlier criterion for detecting an abnormal cell in the battery idle mode.

Specifically, when a time counted by the timer 220 exceeds the minimum rest time (e.g., two hours), as shown in FIG. 3, the processor 230 may obtain a median of the voltage of the entire battery pack based on the initial OCV measurements and calculate the IQR based on the initial OCV measurements on the basis of a first quartile Q1 and a third quartile Q3. The processor 230 may set the outlier criterion for detecting an abnormal cell in a battery idle state using the calculated IQR.

In other words, the outlier criterion for detecting an abnormal cell in the battery idle state may be set to a calculated result value of the following Equation 1.

[Equation 1]

$$\text{outlier criterion} = Q1 - 4.5 * IQR$$

In this case, when the IQR (e.g., 10 mV) is greater than or equal to a set voltage (e.g., 8 mV), the outlier criterion may be set to a result value calculated by applying the determined IQR in Equation 1 (e.g. applying 10mV), and when the IQR (e.g., 6 mV) is less than the set voltage (e.g., 8 mV), the outlier criterion may be set to a result value calculated by applying the set voltage value as the IQR of Equation 1 (e.g. applying 8mV).

The processor 230 may detect an abnormal cell in the battery idle state on the basis of the set outlier criterion. That is, the processor 230 may compare the voltage of each battery cell with the outlier criterion and detect a cell whose voltage is greater than the outlier criterion as an abnormal cell.

As described above, the processor 230 may set the outlier criteria for the entire section to Q1-4.5*IQR and Q3+4.5*IQR and use "Q1-4.5*IQR" corresponding to Median-Min for detecting Min. Cell which has a high reduction rate when the battery is idle alone.

The processor 230 may set IQR=8 mV when IQR<8 mV for a section in which a difference between the cells is small and process Median-Min such that it is not detected when the cell voltage is within 40 mV. The processor 230 may restrict a high voltage connection and prohibit use of the battery in a situation in which the abnormal cell is finally detected.

Meanwhile, when the minimum rest time is not satisfied, the processor 230 may calculate an IQR based on the CCV and set an outlier criterion for detecting an abnormal cell in the battery charging mode.

Specifically, when a time counted by the timer 220 does not exceed the minimum rest time (e.g., two hours), as shown in FIG. 3, the processor 230 may obtain a median of the voltage of the entire battery pack based on the CCV measurements and calculate the IQR based on the CCV measurements on the basis of the first quartile Q1 and the third quartile Q3.

In this case, the processor 230 may calculate the IQR based on the closed circuit voltage only when a battery charge amount (state of charge, or SOC) is greater than or equal to a set charge amount. The processor 230 may set the outlier criterion for detecting an abnormal cell in the battery charging mode using the calculated IQR.

In other words, like the outlier criterion for detecting an abnormal cell in the battery idle state, the outlier criterion for detecting an abnormal cell in the battery charging mode may be set to a calculated result value of Equation 1.

In this case, when the IQR is smaller than a set voltage (e.g., 8 mV), the outlier criterion may be set to a result value calculated by applying the set voltage to the IQR of Equation 1.

The processor 230 may detect an abnormal cell in the battery charging mode on the basis of the set outlier criterion. That is, the processor 230 may compare the voltage of each battery cell with the outlier criterion and detect a cell whose voltage is greater than the outlier criterion as an abnormal cell.

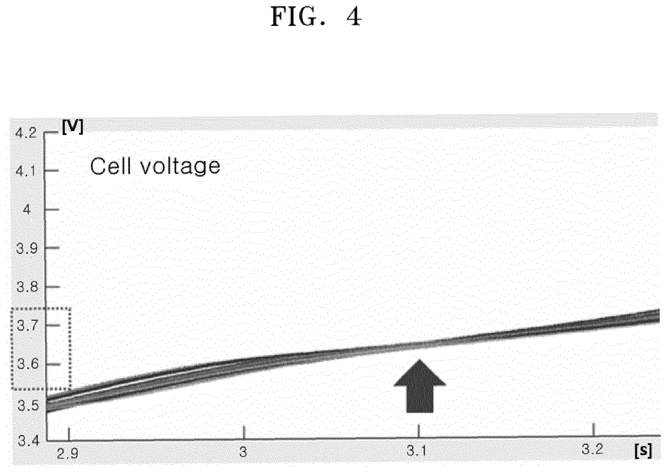

In the battery charging mode, the processor 230 may restrict an SOC section condition and detect an abnormal cell only in an SOC 50% or higher region in a charging mode (plug in charging). In this case, as shown in FIG. 4, in a section (3.6 V to 3.75 V section) in which no deviation between the cells occurs depending on the SOC section, the outlier is detected even with a small deviation so that detection of a normal value can be prevented on the basis of a minimum condition for deviation.

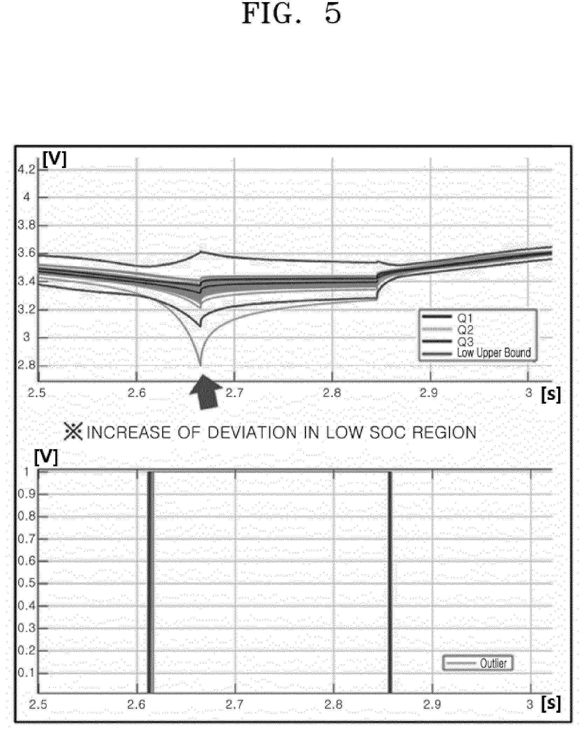

On the other hand, as shown in FIG. 5, it can be seen that, in a region in which an SOC is low, a difference between the cells tends to become worse during discharging. Although the outlier is clear in a section in which the difference between the cells becomes worse, when a voltage difference between the cells is small, such as a specific charging section (3.6 V to 3.75 V section) in FIG. 4, probability of false detection (including normal cells) may increase even with a small change. Therefore, it can be confirmed that, in order to eliminate the probability of false detection, a condition for deviation is needed rather than unconditional statistics.

That is, since a risk is low unless it is a high energy section, the region with a low SOC as shown in FIG. 5 may be excluded from abnormal cell diagnosis. On the other hand, since an SOC of 50% or more changes uniformly during charging, an inter-cell deviation in this section may be used to detect abnormal cells.

The processor 230 may include any one of a BMS, a battery pack control module (BPCM), a central processing control unit (CPU), an electronic control unit (ECU), and a micro controller unit (MCU).

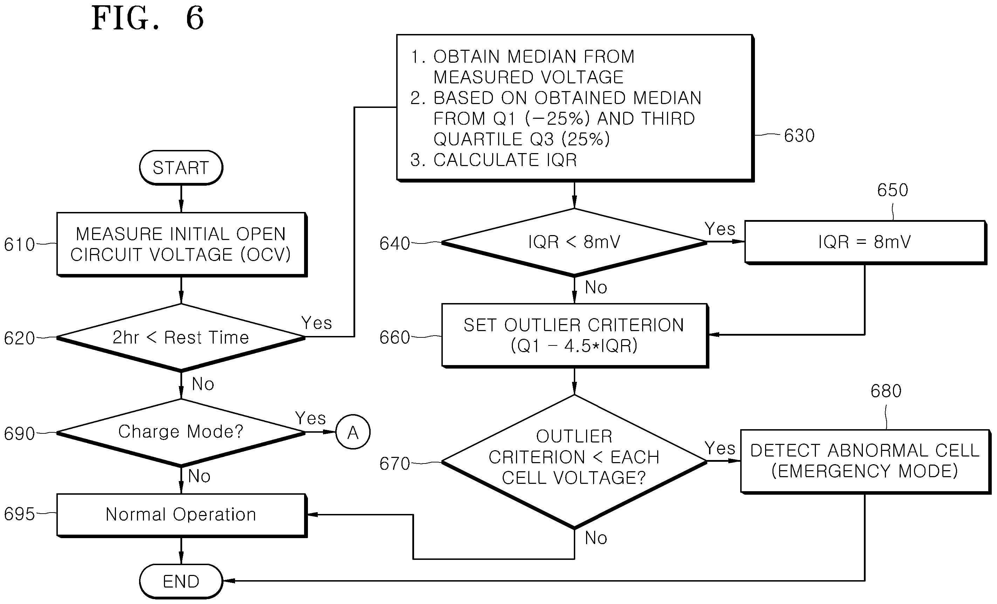

FIG. 6 is a flowchart for describing an abnormal cell diagnosis method using a cell voltage deviation according to one embodiment of the present invention. In particular, FIG. 6 shows a flowchart for describing an abnormal cell diagnosis method in the battery idle mode.

The abnormal cell diagnosis method described herein is merely one example of the present invention. In addition, the present invention is not limited to each operation and sequence described below, and various operations may be added as necessary as follows, and operations below may also be performed in different orders. This can also be applied to other examples below.

Referring to FIGS. 2 and 6, in operation 610, the voltage measurement module 210 may measure an initial OCV of each battery cell.

Next, in operation 620, the processor 230 may determine whether a time counted by the timer 220 for each battery cell satisfies a minimum rest time. In some embodiments the minimum rest time is satisfied when the timer for each battery cell is greater than the minimum rest time, but alternatively the minimum rest time is satisfied when the timer for a single battery cell is greater than the minimum rest time.

In this case, when the minimum rest time is satisfied (i.e. minimum rest time<rest time, which for when the minimum rest time is 2 hours, 2hr < rest time) ("Yes" in 620), in operation 630, the processor 230 may obtain a median of the voltage of the entire battery pack on the basis of the initial OCV for each battery cell and calculate an IQR for the battery pack on the basis of a first quartile Q1 (-25%) and a third quartile Q3 (25%) based on the obtained median.

In this case, when the calculated IQR is smaller than a set voltage (e.g., 8 mV) ("Yes" in 640), the processor 230 may set the IQR value to the set voltage value (e.g. to 8 mV) in operation 650.

Next, in operation 660, the processor 230 may set an outlier criterion using the IQR (e.g., based on the following expression: outlier criterion = Q1-4.5*IQR).

Next, in operation 670, the processor 230 may compare an individual cell voltage with the outlier criterion.

In this case, when the outlier criterion is smaller than the individual cell voltage ("Yes" in 670), the processor 230 may detect a corresponding cell as an abnormal cell in operation 680. On the other hand, when the outlier criterion is not smaller than the individual cell voltage ("No" in 670), the processor 230 may determine that the corresponding cell operates normally.

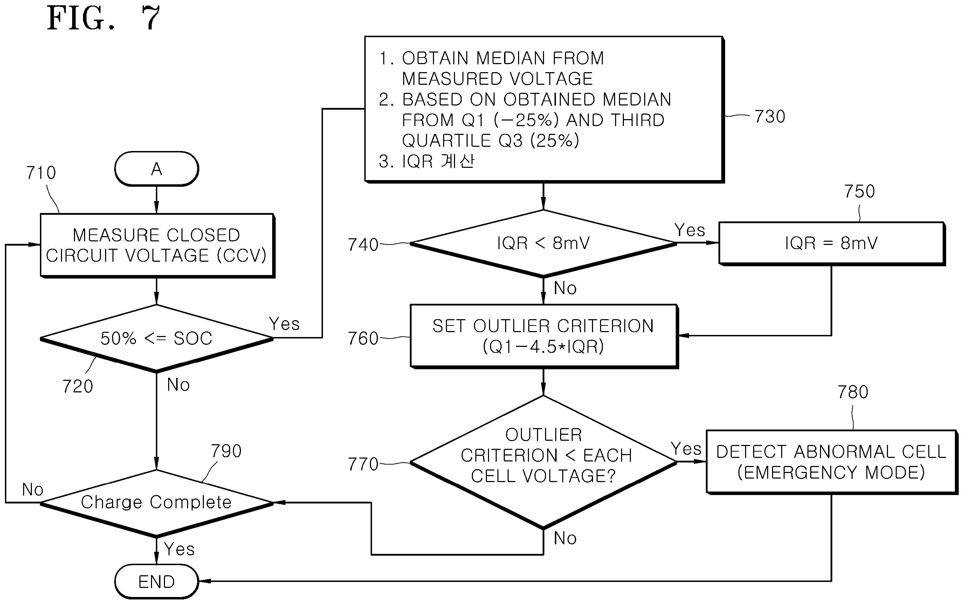

Meanwhile, when the minimum rest time is not satisfied ("No" in 620), the processor 230 may check whether a current mode is a charging mode in operation 690. When the current mode is checked and found to be the charging mode ("Yes" in 690), the processor 230 may perform process A of FIG. 7. On the other hand, when the current mode is checked and found not to be the charging mode ("No" in 690), the processor 230 may determine that the corresponding cell operates normally in operation 695.

FIG. 7 is a flowchart for describing an abnormal cell diagnosis method using a cell voltage deviation according to another embodiment of the present invention. In particular, FIG. 7 shows a flowchart for describing the abnormal cell diagnosis method (process A of FIG. 6) in the battery charging mode.

Referring to FIGS. 2 and 7, in operation 710, the voltage measurement module 210 may measure a CCV of each battery cell.

Next, in operation 720, the processor 230 may check whether a battery charge amount (SOC) for each battery cell is greater than or equal to a set charge amount (e.g., 50%).

In this case, when the SOC is greater than or equal to 50% ("Yes" in 720), in operation 730, the processor 230 may obtain a median of the voltage of the entire battery pack on the basis of the CCV and calculate an IQR on the basis of a first quartile Q1 (-25%) and a third quartile Q3 (25%) based on the obtained median.

In this case, when the calculated IQR is smaller than a set voltage (e.g., 8 mV) ("Yes" in 740), the processor 230 may set the IQR to the set voltage (e.g. 8 mV) in operation 750.

Next, in operation 760, the processor 230 may set an outlier criterion using the IQR (Q1-4.5*IQR).

Next, in operation 770, the processor 230 may compare an individual cell voltage with the outlier criterion.

In this case, when the outlier criterion is smaller than the individual cell voltage ("Yes" in 770), the processor 230 may detect a corresponding cell as an abnormal cell in operation 780. On the other hand, when the outlier criterion is not smaller than the individual cell voltage ("No" in 770), the processor 230 may determine whether charging is completed in operation 790.

Here, operation 790 may be performed even when the SOC is not greater than or equal to 50% ("No" in 720). When the charging is determined to be completed ("Yes" in 790), the present example may be terminated, but when the charging is not completed ("No" in 790), the processor 230 may return to operations 710 and perform the process again.

In accordance with the present invention, a method of finding outliers compared to a median of all battery cell data to acquire battery cell information according to a time point and a situation in which a battery system is operated and use a voltage difference between cells is used so that efficiency of abnormal cell detection can be increased by applying a condition according to a characteristic of a charging state in each section.

In accordance with the present invention, while the existing diagnostic method using an absolute threshold is separately maintained, a method of finding an outlier compared to a median of battery cell data known as an inter quartile range (IQR) is additionally applied to classify the outlier for a characteristic of a value acquired at the same time point so that a problem of false detection in the existing method can be solved.

However, effects that can be achieved through the present invention are not limited to the above-described effects and other effects that are not described may be clearly understood by those skilled in the art from the detailed descriptions.

Although the present invention has been described above with reference to limited embodiments and drawings, the present invention is not limited thereto, and various modifications and variations are possible within the scope of the present invention and the appended claims to be described below by those skilled in the art to which the present invention pertains.

Further Embodiments are set out in the following clauses:

    Clause 1. An abnormal cell diagnosis device using a cell voltage deviation, the abnormal cell diagnosis device comprising:

        a voltage measurement module configured to measure an initial open circuit voltage (OCV) or closed circuit voltage (CCV) of each battery cell; a timer configured to count a minimum rest time for each battery cell; and a processor configured to calculate an inter quartile range (IQR) based on the initial OCV or CCV depending on whether the minimum rest time is satisfied, set an outlier criterion, and detect an abnormal cell on the basis of the set outlier criterion.

    Clause 2. The abnormal cell diagnosis device of clause 1, wherein, when the minimum rest time is satisfied, the processor calculates an IQR based on the initial OCV and sets an outlier criterion for detecting an abnormal cell in a battery idle mode.

Clause 3. The abnormal cell diagnosis device of clause 2, wherein the processor obtains a median value of a voltage of an entire battery pack based on the initial OCV and calculates the IQR on the basis of a first quartile (Q1) and a third quartile (Q3) based on the obtained median.

Clause 4. The abnormal cell diagnosis device of clause 3, wherein the outlier criterion is set to a calculated result value of the following Equation 1:

[Equation 1]

$$outlier\ criterion = Q1 - 4.5 * IQR.$$

Clause 5. The abnormal cell diagnosis device of any preceding clause, wherein, when the minimum rest time is not satisfied, the processor calculates an IQR based on the CCV and sets an outlier criterion for detecting an abnormal cell in a battery charging mode.

Clause 6. The abnormal cell diagnosis device of clause 5, wherein the processor obtains a median value of a voltage of an entire battery pack based on the CCV and calculates the IQR on the basis of a first quartile (Q1) and a third quartile (Q3) based on the obtained median.

Clause 7. The abnormal cell diagnosis device of clause 6, wherein the processor calculates the IQR only when a battery charge amount (SOC) is greater than or equal to a set charge amount.

Clause 8. The abnormal cell diagnosis device of clause 6 or clause 7, wherein the outlier criterion is set to a calculated result value of the following Equation 1:

[Equation 1]

$$outlier\ criterion = Q1 - 4.5 * IQR.$$

Clause 9. An abnormal cell diagnosis method using a cell voltage deviation, the abnormal cell diagnosis method comprising:

measuring, by a processor, an initial open circuit voltage or closed circuit voltage for each battery cell through a voltage measurement module;
counting, by the processor, a minimum rest time for each battery cell through a timer;
calculating, by the processor, an inter quartile range (IQR) based on the initial open circuit voltage or closed circuit voltage depending on whether the minimum rest time is satisfied and setting an outlier criterion; and
detecting, by the processor, an abnormal cell on the basis of the set outlier criterion.

Clause 10. The abnormal cell diagnosis method of clause 9, wherein the setting of the outlier criterion includes:

when the minimum rest time is satisfied, calculating an IQR based on the initial open circuit voltage; and
setting an outlier criterion for detecting an abnormal cell using the calculated IQR in a battery idle state.

Clause 11. The abnormal cell diagnosis method of clause 10, wherein the calculating of the IQR based on the initial open circuit voltage includes:

obtaining a median of a voltage of an entire battery pack based on the initial open circuit voltage; and
calculating the IQR on the basis of a first quartile (Q1) and a third quartile (Q3) based on the obtained median.

Clause 12. The abnormal cell diagnosis method of clause 11, wherein the outlier criterion is set to a calculated result value of the following Equation 1:

[Equation 1]

$$outlier\ criterion = Q1 - 4.5 * IQR.$$

Clause 13. The abnormal cell diagnosis method of any one of clauses 9 - 12, wherein the setting of the outlier criterion includes:

when the minimum rest time is not satisfied, calculating an IQR based on the closed circuit voltage; and
setting an outlier criterion for detecting an abnormal cell using the calculated IQR in a battery charging mode.

Clause 14. The abnormal cell diagnosis method of clause 13, wherein the calculating of the IQR based on the closed circuit voltage includes:

obtaining a median of a voltage of an entire battery pack based on the closed circuit voltage; and

calculating the IQR on the basis of a first quartile (Q1) and a third quartile (Q3) based on the obtained median.

Clause 15. The abnormal cell diagnosis method of clause 13 or clause 14, wherein the calculating of the IQR based on the closed circuit voltage is performed only when a battery charge amount (SOC) is greater than or equal to a set charge amount.

**Claims**

1. An abnormal cell diagnosis device using a cell voltage deviation, the abnormal cell diagnosis device comprising:

   a voltage measurement module configured to measure an initial open circuit voltage (OCV) or closed circuit voltage (CCV) of each battery cell;
   a timer configured to count a rest time for each battery cell; and
   a processor configured to calculate an inter quartile range (IQR) based on the initial OCV or CCV depending on whether the rest time is greater than a minimum rest time, set an outlier criterion, and detect an abnormal cell on the basis of the set outlier criterion.

2. The abnormal cell diagnosis device of claim 1, wherein, when the rest time is greater than the minimum rest time, the processor is configured to calculate an IQR based on the initial OCV and sets an outlier criterion for detecting an abnormal cell in a battery idle mode.

3. The abnormal cell diagnosis device of claim 2, wherein the processor obtains a median value of a voltage of an entire battery pack based on the initial OCV measurements and calculates the IQR on the basis of a first quartile (Q1) and a third quartile (Q3) based on the obtained median.

4. The abnormal cell diagnosis device of claim 3, wherein the outlier criterion is set to a calculated result value according to the equation: outlier criterion = Q 1-4. 5 * IQR.

5. The abnormal cell diagnosis device of any preceding claim, wherein, when the rest time is not greater than the minimum rest time, the processor is configured to calculate an IQR based on the CCV and sets an outlier criterion for detecting an abnormal cell in a battery charging mode.

6. The abnormal cell diagnosis device of claim 5, wherein the processor is configured to obtain a median value of a voltage of an entire battery pack based on the CCV and calculates the IQR on the basis of a first quartile (Q1) and a third quartile (Q3) based on the obtained median.

7. The abnormal cell diagnosis device of claim 6, wherein the processor is configured to calculate the IQR only when a battery charge amount (SOC) is greater than or equal to a set charge amount.

8. The abnormal cell diagnosis device of claim 6 or claim 7, wherein the outlier criterion is set to a calculated result according to the equation: outlier criterion = Q 1-4. 5 * IQR.

9. An abnormal cell diagnosis method using a cell voltage deviation, the abnormal cell diagnosis method comprising:

   measuring, by a processor, an initial open circuit voltage or closed circuit voltage for each battery cell through a voltage measurement module;
   counting, by the processor, a rest time for each battery cell through a timer;
   calculating, by the processor, an inter quartile range (IQR) based on the initial open circuit voltage or closed circuit voltage depending on whether the rest time is greater than a minimum rest time and setting an outlier criterion; and
   detecting, by the processor, an abnormal cell on the basis of the set outlier criterion.

10. The abnormal cell diagnosis method of claim 9, wherein the setting of the outlier criterion includes:

    when the rest time is greater than the minimum rest time, calculating an IQR based on the initial open circuit voltage; and
    setting an outlier criterion for detecting an abnormal cell using the calculated IQR in a battery idle state.

11. The abnormal cell diagnosis method of claim 10, wherein the calculating of the IQR based on the initial open circuit voltage includes:

    obtaining a median of a voltage of an entire battery pack based on the initial open circuit voltage; and
    calculating the IQR on the basis of a first quartile (Q1) and a third quartile (Q3) based on the obtained median.

12. The abnormal cell diagnosis method of claim 11, wherein the outlier criterion is set to a calculated result value of the equation: outlier criterion = Q 1-4. 5 * IQR.

13. The abnormal cell diagnosis method of any one of claims 9 - 12, wherein the setting of the outlier criterion includes:

> when the rest time is not greater than the minimum rest time, calculating an IQR based on the closed circuit voltage; and
> setting an outlier criterion for detecting an abnormal cell using the calculated IQR in a battery charging mode.

14. The abnormal cell diagnosis method of claim 13, wherein the calculating of the IQR based on the closed circuit voltage includes:

> obtaining a median of a voltage of an entire battery pack based on the closed circuit voltage; and
> calculating the IQR on the basis of a first quartile (Q1) and a third quartile (Q3) based on the obtained median.

15. The abnormal cell diagnosis method of claim 13 or claim 14, wherein the calculating of the IQR based on the closed circuit voltage is performed only when a battery charge amount (SOC) is greater than or equal to a set charge amount.

# FIG. 1

# FIG. 2

200

210

230

| VOLTAGE MEASUREMENT MODULE | PROCESSOR |
| TIMER | |

220

FIG. 3

EP 4 614 170 A1

# FIG. 4

# FIG. 5

# FIG. 6

START → 610 MEASURE INITIAL OPEN CIRCUIT VOLTAGE (OCV) → 620 2hr < Rest Time
- Yes → 630
- No → 690 Charge Mode?
  - Yes → A
  - No → 695 Normal Operation → END

630:
1. OBTAIN MEDIAN FROM MEASURED VOLTAGE
2. BASED ON OBTAINED MEDIAN FROM Q1 (~25%) AND THIRD QUARTILE Q3 (25%)
3. CALCULATE IQR

→ 640 IQR < 8mV
- Yes → 650 IQR = 8mV
- No → 660 SET OUTLIER CRITERION (Q1 − 4.5*IQR)

→ 670 OUTLIER CRITERION < EACH CELL VOLTAGE?
- Yes → 680 DETECT ABNORMAL CELL (EMERGENCY MODE)
- No → Normal Operation

## FIG. 7

Flowchart:

**710** MEASURE CLOSED CIRCUIT VOLTAGE (CCV)

**720** 50% <= SOC
- No → **790** Charge Complete
- Yes → (to 730)

**730**
1. OBTAIN MEDIAN FROM MEASURED VOLTAGE
2. BASED ON OBTAINED MEDIAN FROM Q1 (−25%) AND THIRD QUARTILE Q3 (25%)
3. IQR 계산

**740** IQR < 8mV
- Yes → **750** IQR = 8mV
- No → (to 760)

**760** SET OUTLIER CRITERION (Q1−4.5*IQR)

**770** OUTLIER CRITERION < EACH CELL VOLTAGE?
- Yes → **780** DETECT ABNORMAL CELL (EMERGENCY MODE)
- No → **790** Charge Complete

**790** Charge Complete
- No → MEASURE CLOSED CIRCUIT VOLTAGE (710)
- Yes → END

A → MEASURE CLOSED CIRCUIT VOLTAGE

EP 4 614 170 A1

## EUROPEAN SEARCH REPORT

Europäisches
Patentamt
European
Patent Office
Office européen
des brevets

Application Number

EP 24 21 4758

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/057455 A1 (FASCHING RAINER JOHANNES [US] ET AL) 24 February 2022 (2022-02-24) | 1,2,9,10 | INV. G01R31/392 G01R31/396 |
| A | * paragraph [0005] * * paragraphs [0053], [0054], [0058]; figure 1B * * paragraphs [0073], [0074], [0078], [0085]; figure 1E * ----- | 3-8, 11-15 | |
| A | US 2022/057350 A1 (FASCHING RAINER JOHANNES [US] ET AL) 24 February 2022 (2022-02-24) * abstract * * paragraph [0059] - paragraph [0060]; figure 1B * * paragraph [0073] * ----- | 1,2,9,10 | |
| A | WENG CAIHAO ET AL: "A unified open-circuit-voltage model of lithium-ion batteries for state-of-charge estimation and state-of-health monitoring", JOURNAL OF POWER SOURCES, ELSEVIER, AMSTERDAM, NL, vol. 258, 19 February 2014 (2014-02-19), pages 228-237, XP028604622, ISSN: 0378-7753, DOI: 10.1016/J.JPOWSOUR.2014.02.026 * abstract * * penultimate paragraph; page 234, right-hand column * ----- | 1,9 | TECHNICAL FIELDS SEARCHED (IPC) G01R H01M |
| A | KR 2022 0147950 A (HYUNDAI MOBIS CO LTD [KR]) 4 November 2022 (2022-11-04) * abstract * * paragraph [0010] * ----- | 5,13 | |

The present search report has been drawn up for all claims

| Place of search | Date of completion of the search | Examiner |
|---|---|---|
| Munich | 5 May 2025 | Jakob, Clemens |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                    EP 24 21 4758

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2025

| Patent document cited in search report | | Publication date | Patent family member(s) | | Publication date |
|---|---|---|---|---|---|
| US 2022057455 | A1 | 24-02-2022 | CN | 116420087 A | 11-07-2023 |
| | | | DE | 112021004346 T5 | 25-05-2023 |
| | | | US | 11131717 B1 | 28-09-2021 |
| | | | US | 2022057455 A1 | 24-02-2022 |
| | | | US | 2023280412 A1 | 07-09-2023 |
| | | | WO | 2022040036 A1 | 24-02-2022 |
| US 2022057350 | A1 | 24-02-2022 | CN | 116420084 A | 11-07-2023 |
| | | | DE | 112021004361 T5 | 15-06-2023 |
| | | | US | 11125707 B1 | 21-09-2021 |
| | | | US | 2022057350 A1 | 24-02-2022 |
| | | | US | 2023280295 A1 | 07-09-2023 |
| | | | WO | 2022040034 A1 | 24-02-2022 |
| KR 20220147950 | A | 04-11-2022 | NONE | | |

EPO FORM P0459

For more details about this annex : see Official Journal of the European Patent Office, No. 12/82